# EUROPÄISCHE PATENTANMELDUNG

(11) **EP 3 992 498 A1**
(43) Veröffentlichungstag der Anmeldung: **04.05.2022**
(21) Anmeldenummer: 20204725.4
(22) Anmeldetag: 29.10.2020
(51) Int. Cl.: F16H 57/00, F16H 57/025, F16H 57/023, F16H 57/022, F16H 1/10

(54) **ANORDNUNG MIT EINEM GETRIEBE UND EINER ARBEITSMASCHINE, VERFAHREN ZUR SIMULATION**

(71) Anmelder: Flender GmbH, 46395 Bocholt (DE)
(72) Erfinder: Becka, Simon, 46487 Wesel (DE); Schroer, Dirk, 46414 Rhede (DE); Düvel, Volker, 46397 Bocholt (DE)
(74) Vertreter: Michalski Hüttermann & Partner Patentanwälte mbB

(57) **Zusammenfassung**

Die Erfindung betrifft eine Anordnung (ARG) umfassend ein antriebsseitiges Getriebe (GER) mit einer Abtriebswelle (SHB) des Getriebes (GER), die sich entlang einer Achse (X) erstreckt, und umfassend eine Arbeitsmaschine (WMS) mit einer mit der Abtriebswelle (SHB) drehsteif verbundenen Antriebswelle (SHN). Zur Verbesserung der Stabilität und zur Raumersparnis wird vorgeschlagen, dass das Getriebe (GER) an der Arbeitsmaschine (WMS) mittels der Verbindung der Abtriebswelle (SHB) mit der Antriebswelle (SHN) und mittels einer Drehmomentstütze (TSP) zu mindestens 90% der im Betrieb entstehenden Kräfte abgestützt ist, wobei die Verbindung der Abtriebswelle (SHB) mit der Antriebswelle (SHN) biegesteif ausgebildet ist, wobei das axiale Ende der Antriebswelle (SHN) als Hohlwelle (HLW) ausgeführt ist, wobei das axiale Ende der Abtriebswelle (SHB) einen Stumpf (STP) aufweist, der zumindest teilweise in der Hohlwelle (HLW) der Antriebswelle (SHN) angeordnet ist, wobei an einem axialen Ende der Antriebswelle (SHN), mindestens eine erste radiale Antriebswellenzentrierung (RN1) vorgesehen ist, wobei an einem axialen Ende der Abtriebswelle (SHB), an dem die Antriebswelle (SHN) angeschlossen wird, mindestens eine radiale Abtriebswellenzentrierung (RB1) vorgesehen ist, wobei die beiden Zentrierungen radial zentrierend miteinander in Kontakt stehen. Daneben umfasst die Erfindung auch ein computerimplementiertes Verfahren zur Simulation einer Anordnung (ARG) und ein entsprechendes Computerprogrammprodukt zur Durchführung dieses Verfahrens mittels mindestens eines Computers (CMP).

## Beschreibung

Die Erfindung betrifft eine Anordnung umfassend ein antriebsseitiges Getriebe mit einer Abtriebswelle des Getriebes, die sich entlang einer Achse erstreckt, und umfassend eine Arbeitsmaschine mit einer mit der Abtriebswelle drehsteif verbundenen Antriebswelle.

Daneben umfasst die Erfindung auch ein computerimplementiertes Verfahren zur Simulation einer Anordnung und ein entsprechendes Computerprogrammprodukt zur Durchführung dieses Verfahrens mittels mindestens eines Computers.

Derartige Anordnungen sind häufig raumgreifend und neigen infolge höherer Belastungen bei gleichzeitig geforderter Kompaktheit schnell zur Überlastung.

Eine Anwendungsmöglichkeit für eine gattungsgemäße Anordnung ist in der EP2989351-A1 gezeigt.

Ausgehend von den zuvor beschriebenen Problemen liegt der Erfindung die Aufgabe zugrunde, eine zuverlässige Anordnung eingangs definierter Art zu schaffen, die bei moderatem Raumbedarf den hohen anfallenden Lasten standhält.

Zur Lösung der Aufgabe schlägt die Erfindung eine Anordnung der eingangs definierten Art vor, bei der das Getriebe an der Arbeitsmaschine mittels der Verbindung der Abtriebswelle mit der Antriebswelle und mittels einer Drehmomentstütze zu mindestens 90% der im Betrieb entstehenden Kräfte abgestützt ist, wobei die Verbindung der Abtriebswelle mit der Antriebswelle biegesteif ausgebildet ist, wobei das axiale Ende der Antriebswelle als Hohlwelle ausgeführt ist, wobei das axiale Ende der Abtriebswelle einen Stumpf aufweist, der zumindest teilweise in der Hohlwelle der Antriebswelle angeordnet ist.

Die erfindungsgemäße Anordnung umfasst als Getriebe bevorzugt ein Planetengetriebe und ist bevorzugt Bestandteil einer Rollenpresse oder einer Mühle, z.B. einer Zuckermühle, bevorzugt mit Individualantrieb oder diverser anderer Anwendungen im Industriebereich.

Die erfindungsgemäße Anordnung kann hinsichtlich des Getriebes als "wellenreitend gelagert" bezeichnet werden. Dies bedeutet, dass die Abtriebswelle des Getriebes oder Planetengetriebes auf der Antriebswelle der Arbeitsmaschine befestigt ist, derart, dass die Abtriebswelle und das Getriebes dort gegen Querkräfte abgestützt sind. Das Drehmoment am Getriebe bzw. Getriebegehäuse wird mittels einer Drehmomentstütze abgeleitet, z.B. indirekt oder direkt in ein Fundament eingeleitet. Die Ableitung des Drehmoments kann hierbei auch mittels benachbarter Maschinenelemente erfolgen, z.B. über die Arbeitsmaschine, an der die Drehmomentstütze angebracht ist. Die Drehmomentstütze ist hierbei an dem Getriebe derart angebracht, dass das Getriebe an einer axialen Drehung (bzgl. der Abtriebswelle) behindert ist. Andere Freiheitsgrade der Bewegung werden von der Drehmomentstütze bevorzugt nicht eingeschränkt.

Bevorzugt ist die Anordnung derart ausgebildet, dass das Getriebe an der Arbeitsmaschine mittels der Verbindung der Abtriebswelle mit der Antriebswelle und mittels der Drehmomentstütze vollständig gegen die im Betrieb entstehenden Kräfte abgestützt ist.

Eine Eigenschaft dieser Anordnung ist, dass die die Arbeitsmaschinenwelle und die Getriebewelle verbindende Element neben dem Antriebs-Drehmoment auch die Gewichtslasten des Getriebes sowie weiterer Komponenten (Motor, Kupplung, etc.) übertragen muss. Hierdurch entstehen an der Verbindung hohe Biegewechsellasten.

Gemäß der Erfindung ist es möglich, die für die Dimensionierung kritische Kurzverzahnung auf dem maximal möglichen Durchmesser der Abtriebswelle bzw. des Stumpfs vorzusehen. Hierbei ist es besonders zweckmäßig, wenn der Außendurchmesser der Abtriebswellenkurzverzahnung zwischen 85 - 100% des Außendurchmesser des Bereichs der Abtriebswelle aufweist, der an den Stumpf angrenzt. Im Sinne der Erfindung bezeichnet der Begriff "Stumpf" nur einen endseitigen Wellenabschnitt, der insbesondere nicht - gegenüber der übrigen Welle - einen anderen Durchmesser aufweisen muss oder in sonstiger Weise zwingend anders ausgebildet ist. Da über diese Verbindung nicht nur das Antriebs-Drehmoment sondern auch Querkräfte übertragen werden.

Eine vorteilhafte Weiterbildung der Erfindung sieht vor, dass die Antriebswelle modular aufgebaut ist, derart, dass das axiale Ende der Antriebswelle als ein erster Axialabschnitt als ein Flansch ausgebildet ist, der axial an einem zweiten Axialabschnitt der Antriebswelle angebracht ist, wobei der Flansch den endseitigen axialen Wellenabschnitt bildet, der als Hohlwelle ausgebildet ist. Insbesondere ermöglicht dieser modulare Aufbau den Einsatz der erfindungsgemäßen Anordnung mit angrenzenden Standardkomponenten. Standardmäßig kann zur Verbindung von Getriebe- und Arbeitsmaschinenwelle ein Flansch eingesetzt werden. Der Flansch wird bevorzugt mit der Antriebswelle bzw. Arbeitsmaschinenwelle verschraubt.

Besonders kostengünstig und zweckmäßig kann der Flansch als Gussbauteil, insbesondere aus Metall, ausgebildet sein. Bei einer herkömmlichen Anordnung der eingangs definierter Art ist es unter den entsprechend hohen Belastungen nur möglich, den Flansch aus einem höherfesten Material herzustellen. Die Erfindung eröffnet auch den Weg einer Ausführung als Gussbauteil. Ein geschmiedetes Teil ist deutlich teurer als eine vergleichbare Gussvariante.

Eine besonders vorteilhafte Montierbarkeit ergibt sich, wenn die Antriebswelle in dem Bereich der Ausbildung als Hohlwelle eine Ausformung aufweist, wobei an dem als Stumpf ausgebildeten axialen Ende der Abtriebswelle ein Halteelement mittels Befestigungsmitteln befestigt ist, derart, dass die Ausformung in dem Bereich zwischen dem Halteelement und einer axialen Anlagefläche der sonstigen Abtriebswelle eingeklemmt ist. Bevorzugt besteht das Halteelement aus Metall.
Auf diese Weise kann der Flansch an der Abtriebswelle mittels des Halteelements angebracht werden und anschließend kann der Flansch an der Antriebswelle befestigt werden. Besonders zweckmäßig für die Einfachheit der Montage sowie für die Festigkeit und die Laufruhe kann bei der Anordnung der Erfindung das Halteelement, das besonders vorteilhaft ringförmig, also als Haltering ausgebildet sein kann, einteilig ausgeführt werden. Besonders bevorzugt ermöglicht die erfindungsgemäße Anordnung eine freie axiale Zugänglichkeit zu der Montageposition des Halteelements, insbesondere ohne, dass eine sich axial erstreckende Fortsetzung einer Welle eine teilbare - mindestens 2-teilige Ausführung des Halteelements erfordert.

Damit die erfindungsgemäße Anordnung möglichst gut radial ausgerichtet ist, kann an einem axialen Ende der Antriebswelle, mindestens eine erste radiale Antriebswellenzentrierung vorgesehen sein, wobei an einem axialen Ende der Abtriebswelle, an dem die Antriebswelle angeschlossen wird, mindestens eine radiale Abtriebswellenzentrierung vorgesehen ist, wobei die beiden Zentrierungen radial zentrierend miteinander in Kontakt stehen.

Eine besonders vorteilhafte Möglichkeit diese Biegesteifigkeit herzustellen besteht darin, dass an dem axialen Ende der Antriebswelle, eine zu der ersten radialen Antriebswellenzentrierung axial beabstandete zweite radiale Antriebswellenzentrierung vorgesehen ist, wobei an dem axialen Ende der Abtriebswelle, eine zu der ersten radialen Abtriebswellenzentrierung axial beabstandete zweite radiale Abtriebswellenzentrierung vorgesehen ist, wobei die Abtriebswellenzentrierungen und Antriebswellenzentrierungen paarweise zueinander zu zwei axial beabstandeten Zentrierungspaaren zugeordnet sind und jeweils radial zentrierend miteinander in Kontakt stehen.

Getriebeseitig wird der Flansch bei der Montage bevorzugt in die Abtriebswelle gesteckt, welche besonders bevozugt als Hohlwelle mit der innenliegenden Kurzverzahnung sowie zwei Zentriersitzen ausgeführt ist. Die Biegelasten werden so über die Zentriersitze, die Drehmomente über die Kurzverzahnung übertragen. Die axiale Verschiebung der Komponenten zueinander wird durch das Haltelement, bevorzugt ausgebildet als Haltering, verhindert. Dieser kann in Umfangsrichtung ungeteilt ausgeführt werden.

Dimensionierendes Kriterium für den Flansch ist der maximal mögliche Innendurchmesser an der Getriebeabtriebswelle. Dieser ist über ein Mindestdickenverhältnis an den Außendurchmesser der Welle gekoppelt. Mit steigender Drehmomentdichte wird der Außendurchmesser der Getriebeabtriebswelle immer kleiner, wodurch auch der mögliche Innendurchmesser kleiner wird. Dies führt ebenfalls zu einem kleineren Zapfen an dem Flansch, wodurch die auftretenden Biegewechsellasten zum dimensionierenden Kriterium werden. Hier entfaltet die erfindungsgemäße Lösung ihre Stärken.

Das bevorzugte Einsatzgebiet der Erfindung liegt im Bereich von Getrieben, wie sie an Mühlen, z.B. Zuckermühlen vorgesehen sind. Diese Getriebe sind bevorzugt als Planetengetriebe ausgebildet.

Vorteile und Ausgestaltungen der Erfindung, die einzeln oder in Kombination miteinander einsetzbar sind, sind Gegenstand der Unteransprüche.

Die Erfindung bezieht sich auch auf ein computerimplementiertes Verfahren zur Simulation eine Anordnung nach mindestens einer durch die Ansprüche definierte Merkmalskombination. Dementsprechend umfasst die Erfindung einerseits das körperliche Gebilde mit den erfindungsgemäßen Merkmalen und andererseits auch einen digitalen Zwilling, wie er beispielsweise zum Zwecke der Simulation der Anordnung bzw. des Betriebes der Anordnung mittels mindestens eines Computers eingesetzt wird. Daneben bezieht sich die Erfindung auch auf ein entsprechendes Computerprogrammprodukt.

Weitere Merkmale, Eigenschaften und Vorteile der vorliegenden Erfindung ergeben sich aus der nachfolgenden Beschreibung unter Bezugnahme auf die Figuren. Darin zeigen schematisch:
- Figur 1: eine vereinfachte, zweidimensionale Längsschnittdarstellung einer erfindungsgemäßen Anordnung,
- Figur 2: eine schematische Darstellung einer auf einem Computer ablaufenden Simulation einer Anordnung nach der Erfindung, Computerprogrammprodukt.

In den Ausführungsbeispielen und Figuren können gleiche oder gleich wirkende Elemente jeweils mit den gleichen Bezugszeichen versehen sein. Die dargestellten Elemente und deren Größenverhältnisse untereinander sind grundsätzlich nicht als maßstabsgerecht anzusehen, vielmehr können einzelne Elemente, zur besseren Darstellbarkeit und/oder zum besseren Verständnis im Verhältnis größer dimensioniert dargestellt sein.

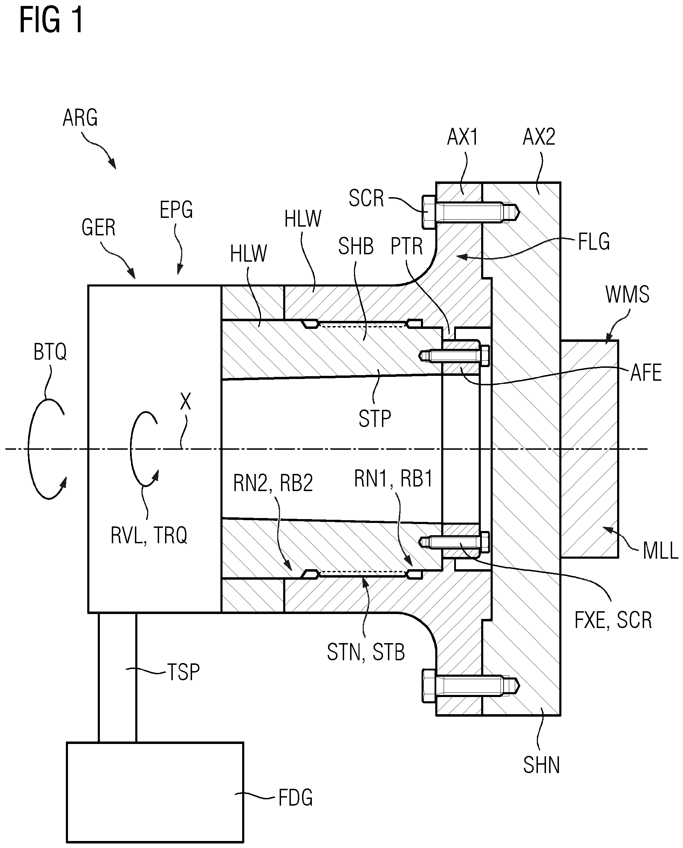

Figur 1 zeigt eine vereinfachte, zweidimensionale Längsschnittdarstellung einer erfindungsgemäßen Anordnung ARG mit einer Abtriebswelle SHB eines Getriebes GER, die sich entlang einer Achse X erstreckt. Das Getriebe GER ist als Planetengetriebe EPG ausgebildet. Die Abtriebswelle SHB ist mit einer Antriebswelle SHN drehsteif und biegesteif verbundenen. Die Antriebswelle SHN steht mit einer Arbeitsmaschine, insbesondere einer Mühle MLL in drehmomentübertragender Verbindung. Das Getriebe GER ist an der Arbeitsmaschine WMS mittels der Verbindung der Abtriebswelle SHB mit der Antriebswelle SHN und mittels einer Drehmomentstütze TSP zu mindestens 90% - bevorzugt vollständig - der im Betrieb entstehenden Kräfte abgestützt. Kräfte BTQ (insbesondere Biegelasten, Querkräfte) aus dem nicht dargestellten Antrieb des Getriebes GER, werden in die Antriebswelle SHN und die Drehmomentstütze TSP (hier insbesondere Kräfte aus einem Differenzdrehmoment infolge des Getriebes GER) eingeleitet. Das Drehmoment am Getriebe GER bzw. Getriebegehäuse wird mittels der Drehmomentstütze TSP abgeleitet, z.B. indirekt oder direkt in ein Fundament FDG eingeleitet.

An einem axialen Ende der Antriebswelle SHN ist die Abtriebswelle SHB angeschlossen. Mittels einer Abtriebswellenkurzverzahnung STB wird ein Drehmoment TRQ mit einer Drehzahl RVL übertragen von der Abtriebswelle SHB auf eine Antriebswellenkurzverzahnung STN der Antriebswelle SHN.
Das axiale Ende der Antriebswelle SHN, das an der Abtriebswelle SHB angeschlossen ist, ist als Hohlwelle HLW ausgeführt. Hierbei weist das axiale Ende der Abtriebswelle SHB einen Stumpf STP auf, der zumindest teilweise in der Hohlwelle HLW der Antriebswelle SHN angeordnet ist.

Die Antriebswelle SHN ist modular aufgebaut, derart, dass das axiale Ende der Antriebswelle SHN als ein erster Axialabschnitt AX1 als ein Flansch FLG ausgebildet ist, der axial an einem zweiten Axialabschnitt AX2 der Antriebswelle SHN angebracht ist, wobei der Flansch FLG den endseitigen axialen Wellenabschnitt bildet, der als Hohlwelle HLW ausgebildet ist. Der Flansch FLG ist an dem zweiten Axialabschnitt AX2 mittels Schrauben SCR befestigt und als Gussbauteil, insbesondere aus Metall, ausgebildet.

Die Antriebswelle SHN weist in dem Bereich der Ausbildung als Hohlwelle HLW eine radial nach innen ragende Ausformung PTR auf, wobei an dem als Stumpf STP ausgebildeten axialen Ende der Abtriebswelle SHB ein Halteelement AFE mittels axial wirkenden Befestigungsmitteln FXE Schrauben SCR befestigt ist, derart, dass die Ausformung PTR in dem Bereich zwischen dem Halteelement AFE und einer axialen Anlagefläche der sonstigen Abtriebswelle SHB eingeklemmt ist.

Das Halteelement AFE ist ringförmig und in Umfangsrichtung einteilig ausgebildet.

An dem axialen Ende der Antriebswelle SHN ist eine erste radiale Antriebswellenzentrierung RN1 vorgesehen und an dem axialen Ende der Abtriebswelle SHB, an dem die Antriebswelle SHN angeschlossen wird, ist eine radiale Abtriebswellenzentrierung RB1 vorgesehen ist, wobei die beiden Zentrierungen radial zentrierend miteinander in Kontakt stehen.

Die Verbindung der Abtriebswelle SHB mit der Antriebswelle SHN ist biegesteif ausgebildet, dadurch, dass an dem axialen Ende der Antriebswelle SHN, eine zu der ersten radialen Antriebswellenzentrierung RN1 axial beabstandete zweite radiale Antriebswellenzentrierung RN2 vorgesehen ist, wobei an dem axialen Ende der Abtriebswelle SHB, eine zu der ersten radialen Abtriebswellenzentrierung RB1 axial beabstandete zweite radiale Abtriebswellenzentrierung RB2 vorgesehen ist, wobei die Abtriebswellenzentrierungen RB1, RB2 und Antriebswellenzentrierungen RN1, RN2 paarweise zueinander zu zwei axial beabstandeten Zentrierungspaaren zugeordnet sind und jeweils radial zentrierend miteinander in Kontakt stehen.

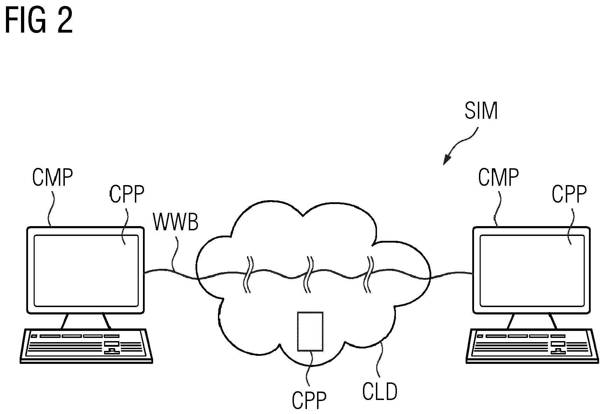

Figur 2 zeigt eine schematische Darstellung einer auf einem Computer CMP - hier auf mehreren Computern CMP eines Netzwerks WWB umfassend eine Cloud CLD - ablaufenden Simulation SIM einer Anordnung ARG nach der Erfindung. Die auf den Computern CMP installierte Software ist ein Computerprogrammprodukt CPP, das bei Ausführung auf mindestens einem Computer CMP dem Benutzer mittels Schnittstellen Bildschirm, Tastatur eine Einflussnahme bzw. Konfiguration und einen Erkenntnisgewinn auf Basis der ausgeführten Simulation SIM ermöglicht, so dass insbesondere technische Gestaltungsentscheidungen mittels der Simulation unterstützt und verifiziert werden können.

Obwohl die Erfindung im Detail durch das bevorzugte Ausführungsbeispiel näher illustriert und beschrieben wurde, ist die Erfindung nicht durch die offenbarten Beispiele eingeschränkt. Variationen hiervon können vom Fachmann abgeleitet werden, ohne den Schutzumfang der Erfindung, wie er durch die nachfolgenden Patentansprüche definiert wird, zu verlassen.

## Patentansprüche

1. Anordnung (ARG) umfassend ein antriebsseitiges Getriebe (GER) mit einer Abtriebswelle (SHB) des Getriebes (GER), die sich entlang einer Achse (X) erstreckt, und umfassend eine Arbeitsmaschine (WMS) mit einer mit der Abtriebswelle (SHB) drehsteif verbundenen Antriebswelle (SHN),
**dadurch gekennzeichnet, dass**
das Getriebe (GER) an der Arbeitsmaschine (WMS) mittels der Verbindung der Abtriebswelle (SHB) mit der Antriebswelle (SHN) und mittels einer Drehmomentstütze (TSP) zu mindestens 90% der im Betrieb entstehenden Kräfte abgestützt ist, wobei die Verbindung der Abtriebswelle (SHB) mit der Antriebswelle (SHN) biegesteif ausgebildet ist,
wobei das axiale Ende der Antriebswelle (SHN) als Hohlwelle (HLW) ausgeführt ist,
wobei das axiale Ende der Abtriebswelle (SHB) einen Stumpf (STP) aufweist, der zumindest teilweise in der Hohlwelle (HLW) der Antriebswelle (SHN) angeordnet ist.

2. Anordnung (ARG) nach Anspruch 1, wobei die Antriebswelle (SHN) modular aufgebaut ist, derart, dass das axiale Ende der Antriebswelle (SHN) als ein erster Axialabschnitt (AX1) als ein Flansch (FLG) ausgebildet ist, der axial an einem zweiten Axialabschnitt (AX2) der Antriebswelle (SHN) angebracht ist, wobei der Flansch (FLG) den endseitigen axialen Wellenabschnitt bildet, der als Hohlwelle (HLW) ausgebildet ist.

3. Anordnung (ARG) nach Anspruch 1 oder 2, wobei der Flansch (FLG) als Gussbauteil ausgebildet ist.

4. Anordnung (ARG) nach einem der vorhergehenden Ansprüche, wobei die Antriebswelle (SHN) in dem Bereich der Ausbildung als Hohlwelle (HLW) eine Ausformung (PTR) aufweist,
wobei an dem als Stumpf (STP) ausgebildeten axialen Ende der Abtriebswelle (SHB) ein Halteelement (AFE) mittels Befestigungsmitteln (FXE) befestigt ist, derart, dass die Ausformung (PTR) in dem Bereich zwischen dem Halteelement (AFE) und einer axialen Anlagefläche der sonstigen Abtriebswelle (SHB) eingeklemmt ist.

5. Anordnung (ARG) nach mindestens dem vorhergehenden Anspruch 2, wobei das Halteelement (AFE) rund oder ringförmig ausgebildet ist.

6. Anordnung (ARG) nach einem der vorhergehenden Ansprüche, wobei an einem axialen Ende der Abtriebswelle (SHB), an dem die Antriebswelle (SHN) angeschlossen wird, eine Abtriebswellenkurzverzahnung (STD) vorgesehen sind,
wobei an einem axialen Ende der Antriebswelle (SHN), an dem die Abtriebswelle (SHB) angeschlossen wird, eine Antriebswellenkurzverzahnung (STN) vorgesehen sind.

7. Anordnung (ARG) nach einem der vorhergehenden Ansprüche, wobei das Getriebe (GER) an der Arbeitsmaschine (WMS) mittels der Verbindung der Abtriebswelle (SHB) mit der Antriebswelle (SHN) und mittels der Drehmomentstütze (TSP) vollständig gegen die im Betrieb entstehenden Kräfte abgestützt ist.

8. Anordnung (ARG) nach mindestens einem der vorhergehenden Ansprüche, wobei an einem axialen Ende der Antriebswelle (SHN), mindestens eine erste radiale Antriebswellenzentrierung (RN1) vorgesehen ist,
wobei an einem axialen Ende der Abtriebswelle (SHB), an dem die Antriebswelle (SHN) angeschlossen wird, mindestens eine radiale Abtriebswellenzentrierung (RB1) vorgesehen ist, wobei die beiden Zentrierungen radial zentrierend miteinander in Kontakt stehen.

9. Anordnung (ARG) nach mindestens dem der vorhergehenden Anspruch 8, wobei an dem axialen Ende der Antriebswelle (SHN), eine zu der ersten radialen Antriebswellenzentrierung (RN1) axial beabstandete zweite radiale Antriebswellenzentrierung (RN2) vorgesehen ist,
wobei an dem axialen Ende der Abtriebswelle (SHB), eine zu der ersten radialen Abtriebswellenzentrierung (RB1) axial beabstandete zweite radiale Abtriebswellenzentrierung (RB2) vorgesehen ist, wobei die Abtriebswellenzentrierungen (RB1, RB2) und Antriebswellenzentrierungen (RN1, RN2) paarweise zueinander zu zwei axial beabstandeten Zentrierungspaaren zugeordnet sind und jeweils radial zentrierend miteinander in Kontakt stehen.

10. Anordnung (ARG) nach mindestens einem der vorhergehenden Ansprüche, wobei die Abtriebswelle (SHB) und/oder die Antriebswelle (SHN) und/oder die Drehmomentstütze (TSP) und/oder der Flansch (FLG) aus Metall bestehen.

11. Computerimplementiertes Verfahren zur Simulation (SIM) einer Anordnung (ARG) nach mindestens einem der vorhergehenden Ansprüche.

12. Computerprogrammprodukt (CPP) zur Durchführung eines Verfahrens nach Anspruch 11 mittels mindestens eines Computers (CMP).
